# EUROPEAN PATENT APPLICATION

(11) **EP 2 503 616 A1**
(43) Date of publication of application: **26.09.2012**
(21) Application number: 11159043.6
(22) Date of filing: 21.03.2011
(51) Int. Cl.: H01L 51/50, H01L 51/00

(54) **Emissive element for light emitting device, light emitting device and method for manufacturing such element and device**

(71) Applicant: Polyphotonix Limited, Sedgefield County, Durham TS21 3FG (GB)
(72) Inventor: Veres, Janos, Sedgefield, Co Durham TS21 3FG (GB)
(74) Representative: Vinsome, Rex Martin

(57) **Abstract**

An emissive element for a device (700) for emitting electromagnetic radiation is disclosed. The emissive element comprises at least one emissive layer (706) including at least one organic material, and a plurality of interconnect islands (703, 704) embedded in at least one predetermined said emissive layer and separated from each other. Each of a plurality of said interconnect islands comprises respective electron injecting means (703A, 704A) and respective hole injecting means (703B, 704B), wherein at least one emissive domain is defined by at least part of said electron injecting means of a respective first said interconnect island, at least part of said hole injecting means of a respective second said interconnect island adjacent said first interconnect island and a respective region of said emissive layer separating said electron injecting means and said hole injecting means. Application of a suitable electric field to the emissive layer in use in a device for emitting electromagnetic radiation causes electron injecting means and hole injecting means of at least one said domain to supply electrons and holes respectively, to cause said at least one said emissive domain to emit electromagnetic radiation.

## Description

### Field of the invention

The present invention relates to light emitting devices and to emissive elements for such devices, and to methods for manufacturing such elements and light emitting devices. The method relates particularly, but not exclusively, to organic light emitting diodes (OLEDs) and methods of manufacturing OLEDs.

### Background of the invention

Organic light emitting diodes typically comprise very thin layers, having thicknesses of the order of tens or hundreds of nanometres, in order to maximise their efficiency.

Substrate defects or particulate defects incorporated in such films cause short circuits between electrodes. To avoid such defects extreme care should be taken to choose defect free, clean substrates and clean manufacturing conditions.

The layer thickness of typical OLED devices also creates structures which may experience strong interference and other optical effects such as surface plasmon resonances, which can limit device design possibilities and efficiency. A number of techniques have been developed to reduce these optical effects, which further complicates the manufacturing process.

Conventional OLED devices also suffer from the drawback that the manufacturing techniques used to produce the thin layers required are highly inefficient in their consumption of material, and often use solvent materials which can create a potential environmental hazard.

Solutions to both of these problems can be found by providing thicker transport or interface layers coated on the anode or cathode and larger distances between the anode and cathode to limit interference effects.

In order to make OLED devices more efficient, often multiple layers are provided with specific functionalities such as luminescence, electroluminescence, phosphorescence, charge transport, charge injection, charge blocking or optical spacer layers, and the thickness of a particular layer is determined by its functionality. A typical layer thickness used in OLED is between a few nanometers and a micron. Most layers are typically 10 to 100 nanometres thick, which presents significant challenges to their uniform deposition. The two techniques commonly used to deposit OLED materials are (i) vacuum evaporation and (ii) solution coating. Solution coating of multilayer devices is a challenge as solvents can easily disturb or dissolve underlying layers. Therefore multilayer devices are easier to fabricate via evaporation processes but evaporation is not suited to large area processing.

A particularly useful multilayer device is called the tandem OLED device, in which at least two OLED devices are connected in series, by stacking OLED devices on top of each other. Tandem and stacked devices are disclosed for example in US6,337,492, US6,717,358 and US2009191428. Such architecture allows building a stack of different colours in order to tune the emission of the overall device. Tandem OLED devices also have the advantage of high current efficiency, as a result of which the current can be kept low, which in turn enables operating lifetime to be improved. However, such devices are still very sensitive to defects and are complex to manufacture due to the many subsequent layers coated. Also, because of the thin films used, OLED devices must generally be formed on rigid planar substrates, which in turn limits the range of possible device designs.

### Summary of the invention

There is a need for OLED devices that can be prepared with greater yield and simplicity. There is also a need for devices that are more power efficient. Importantly, there is also a need for devices and processes that can depart from planar shape to fulfil design requirements for curved, concave or convex light-emitting devices.

Preferred embodiments of the present invention seek to overcome one or more of the above disadvantages of the prior art.

According to an aspect of the present invention, there is provided an emissive element for a device for emitting electromagnetic radiation, the emissive element comprising:-
at least one emissive layer including at least one organic material; and
a plurality of interconnect islands embedded in at least one predetermined said emissive layer and separated from each other, wherein each of a plurality of said interconnect islands comprises respective electron injecting means and respective hole injecting means, wherein at least one emissive domain is defined by at least part of said electron injecting means of a respective first said interconnect island, at least part of said hole injecting means of a respective second said interconnect island adjacent said first interconnect island and a respective region of said emissive layer separating said electron injecting means and said hole injecting means, and wherein application of a suitable electric field to the emissive layer in use in a device for emitting electromagnetic radiation causes electron injecting means and hole injecting means of at least one said domain to supply electrons and holes respectively, to cause said at least one said emissive domain to emit electromagnetic radiation.

The present invention is based on the surprising discovery that by providing a plurality of interconnect islands embedded in at least one predetermined said emissive layer and separated from each other, wherein each of a plurality of said interconnect islands comprises respective electron injecting means and respective hole injecting means, wherein at least one emissive domain is defined by at least part of said electron injecting means of a respective first said interconnect island, at least part of said hole injecting means of a respective second said interconnect island adjacent said first interconnect island and a respective region of said emissive layer separating said electron injecting means and said hole injecting means, a multidomain OLED device can be formed. This may be achieved, for example, by including discrete metallic, semiconducting, or hybrid islands in an otherwise single layer organic light emitting material. Such a multidomain structure can be several microns thick, which makes its manufacture much more robust than that of nanometre thick conventional layers. In addition, a variety of new process technologies can be used to fabricate such devices, making it possible, for example, to form curved or three dimensional light emitting devices. The device architecture also enables a device design tuned for low current, higher voltage operation with advantages such as improved lifetime, reduced defect breakdown, improved current efficiency.

It will be appreciated by persons skilled in the art that the emissive layer need not be flat or of uniform thickness, and may have a variety of shapes and thicknesses. It will also be appreciated that the terms "electron injecting means" and "hole injecting means" comprise any device or material which will perform the necessary respective electron or hole injecting function, such as regions of interconnect islands defining electron or hole injecting surfaces, or pendant groups or functional parts of molecules. It will also be appreciated that the term "emissive element" covers a product which can be used as a component in the manufacture of devices for emitting electromagnetic radiation, for example by means of the addition of suitable electrodes, and further layers such as electron or hole transport layers.

At least one said emissive layer may include at least one organic electroluminescent material.

At least one said interconnect island may include nanoparticles and/or nanowires and/or flakes.

At least one said interconnect island may include at least one metallic material and/or at least one semiconducting material and/or at least one organic material.

At least one said interconnect island may include clusters of least one said metallic material and/or at least one said semiconducting material and/or at least one said organic material.

At least one said interconnect island may comprise at least one coating and/or surface treatment for enabling and/or enhancing electron and/or hole injection by said island.

At least one said emissive layer may include at least one polymeric material.

At least one said electron injecting means may comprise at least one respective electron injecting surface substantially in a plane substantially parallel to at least one first and/or second surface of said layer, and/or wherein at least one said hole injecting means comprises at least one respective hole injecting surface substantially in a plane substantially parallel to at least one said first and/or second surface of said layer.

A plurality of said interconnect islands may be elongate with respective electron injecting means and hole injecting means provided adjacent opposite ends thereof.

According to another aspect of the present invention, there is provided a device for emitting electromagnetic radiation, the device comprising:
at least one first electrode;
at least one second electrode; and
at least one element as defined above arranged between at least one said first electrode and at least one said second electrode.

According to a further aspect of the present invention, there is provided a material for forming an emissive element for a device for emitting electromagnetic radiation, the material comprising an emissive material including at least one organic material, and a plurality of interconnect islands embedded in said emissive material, wherein each of a plurality of said interconnect islands comprises respective electron injecting means and/or respective hole injecting means.

The emissive material may be adapted to be made flowable at room temperature by means of at least one solvent and/or may be adapted to be made flowable by means of melting.

According to a further aspect of the present invention, there is provided a method of manufacturing an emissive element for a device for emitting electromagnetic radiation, the method comprising:-
providing at least one flowable material including at least one organic material;
introducing a plurality of components into said flowable material wherein a plurality of said components comprise respective electron injecting means and/or respective hole injecting means; and
forming a layer from said flowable material together with said components such that a plurality of said components are embedded in said layer and separated from each other.

The method may further comprise the step of treating at least one said component, subsequently to formation of said layer, to create and/or enhance respective electron injecting means and/or respective hole injecting means.

The layer may be formed by means of melt processing and/or solution processing and/or extrusion and/or extrusion printing and/or solution coating and/or moulding and/or spraying and/or inkjet printing.

A plurality of said components may be dispersed in said flowable material by means of preferential dispersion in a polymer phase and/or dissolution in a polymer phase.

The surfaces of the islands can be defined by sequential deposition of different materials, by differential doping or by growing the domains with a gradient. For example the islands can consist of bilayer metal flakes, which may be planar or shaped in some fashion, for example buckled, with two different surfaces. The islands may also comprise nanowires, each having two different surfaces. Such nanowires can be formed, for example, by changing the growth conditions in chemical vapour deposition (CVD.)

The islands may comprise nanoparticle aggregates of different metal or semiconducting particles. In each case a flake, wire or particle containing islands may have two different surfaces for electron and hole injection, respectively. The islands may also comprise organic molecules, for example aggregates of materials used in tandem OLED devices. The aggregation of different materials within islands can be achieved by a dispersion technique or by covalently binding materials together.

The inclusion of interconnect islands, which can be randomly dispersed, can be achieved by solution mixing, dispersion or co-deposition from two sources e.g. by spray coating simultaneously from two nozzles the emissive materials and an island containing material. Co-deposition is also achievable in an evaporation process by periodically shuttering the deposition from metal sources.

The islands can be included in the emissive layer by dispersing them, for example by using a block copolymer matrix, confining the interconnect domains to one phase.

The islands and the OLED material can also be mixed by a heat melt extrusion process.

A particularly advantageous feature of the invention is that it enables several micron thick OLED layers, which can be deposited by moulding or thermal forming. The composite architecture may also be deposited by hot melt extrusion or extrusion printing to enable curved surfaces or three dimensional light emitting surfaces. When hot melt extrusion is used, the composition may further comprise additives such as plasticisers, for example carbon dioxide or solvents.

The islands may be aligned if required by the coating process itself, for example by extrusion, curtain coating or slit die coating. The islands may also be aligned or shaped by any other suitable technique such as electric, magnetic field or pressure.

The islands may be random in size. The islands may also be random in their distribution vertically or horizontally across the film. The islands may also exhibit randomness in orientation. Similarly the islands may be ordered to produce structures of electrical or optical significance, such as optical interference structures or buckled structures in order to take advantage of or suppress optical effects such as surface plasmon resonances, interference and optical field.

The matrix in which the islands are dispersed or distributed may comprise at least one electroluminescent material and optionally further electroluminescent, phosphorescent, host materials, transport or binder materials and/or dopants. These materials may be polymeric or small molecule or both. Optionally the composition may comprise inorganic quantum dots for emission or other structures such as fluorophore filled nanoparticles.

### Brief description of the drawings

Preferred embodiments of the invention will now be described, by way of example only and not in any limitative sense, with reference to the accompanying drawings.

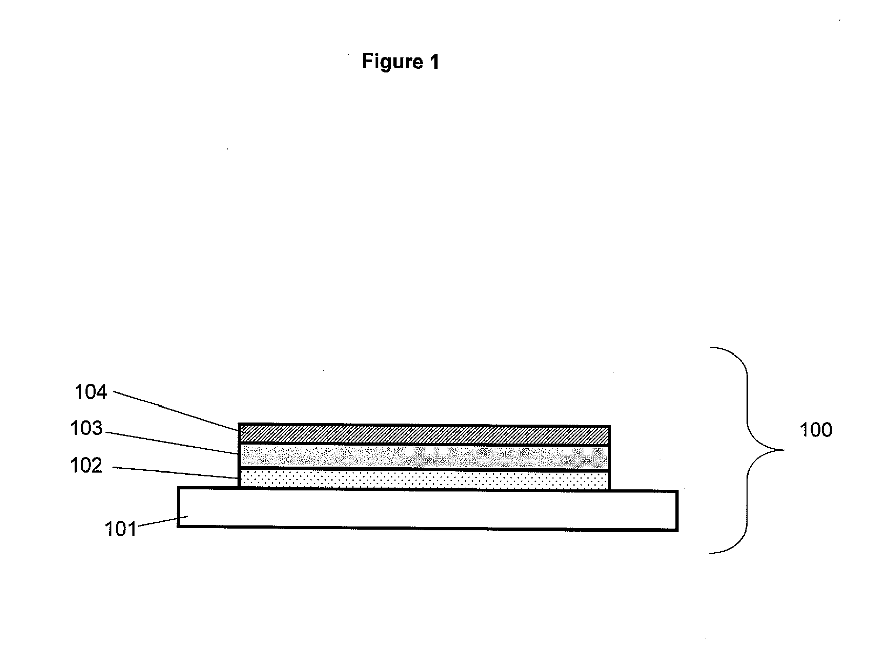

Figure 1 is a schematic side cross-sectional view of a prior art, conventional single layer OLED device 100. The device is disposed on substrate 101, having an electroluminescent layer 103 sandwiched between two electrodes 102 and 104. One of the electrodes is semitransparent.

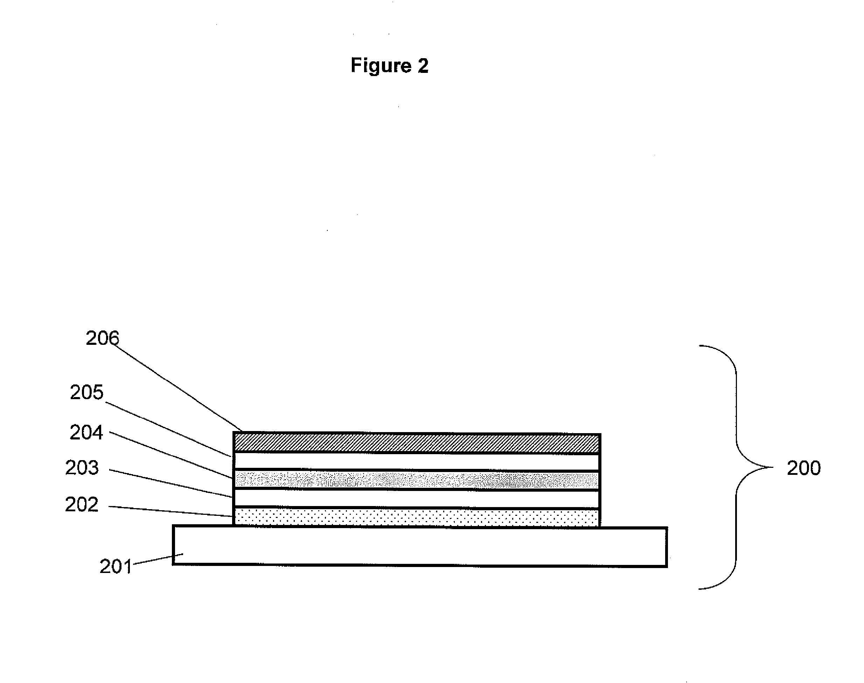

Figure 2 is a schematic side cross-section view of a prior art, conventional multilayer device 200 with separate transport layers 203 and 205 for holes and electrons respectively on either side of an emissive layer 204. The device has two sets of electrodes 202 and 206, one of which is semitransparent. This arrangement corresponds to that disclosed in Tang et al. J. Applied Physics, 65, 3610-3616 (1989).

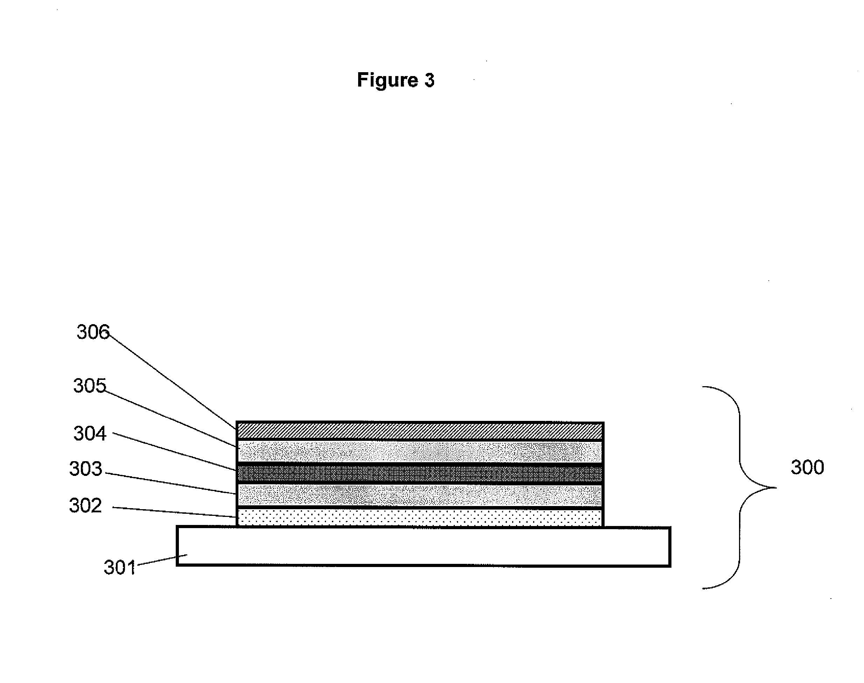

Figure 3 is a schematic side cross-section view of a prior art, conventional tandem device 300, consisting of two single layer emitters 303 and 305. Between the two layers an interconnect layer 304 is inserted. The device has two electrodes 302 and 306, one of which is semitransparent.

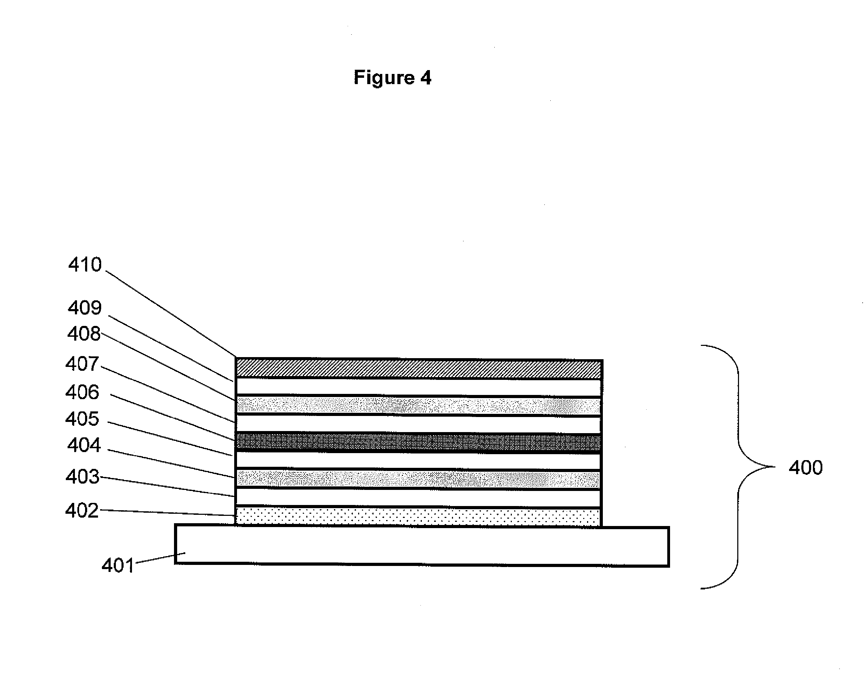

Figure 4 is a schematic side cross-section view of a prior art, conventional tandem device 400, consisting of two multilayer tandem emitters. The two tandem devices are connected with electrode 406. Each device has transport layers 403, 405, 407, 409 on either side of emissive layers 404 and 408 respectively. The device has two electrodes 402 and 410, one of which is semitransparent.

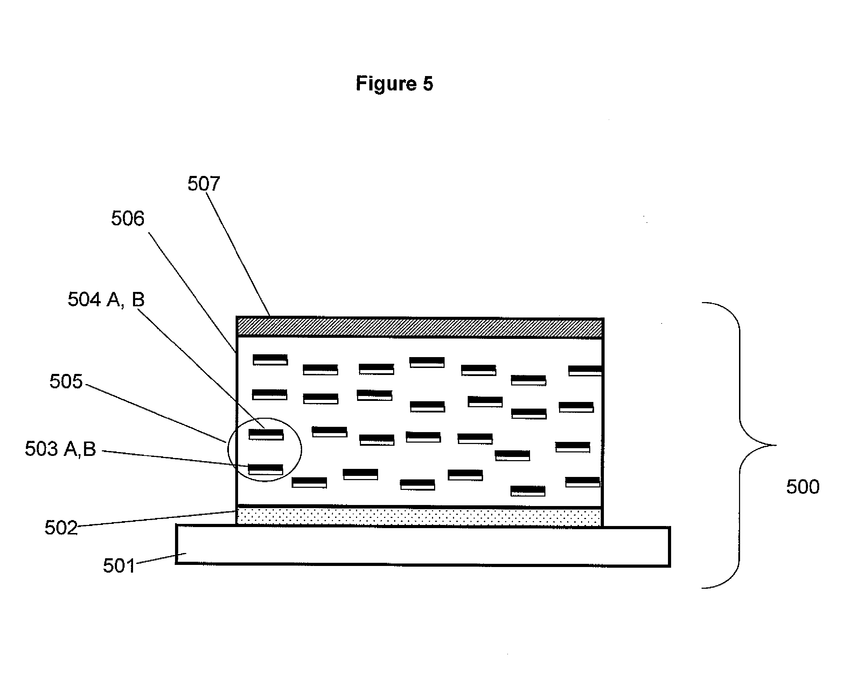

Figure 5 is a schematic side cross-section view of a multidomain organic light emitting diode (OLED) device 500 according to the present invention, in which interconnect islands are embedded randomly in an emissive matrix 506. These islands e.g. 503 and 504 are flat, having different upper and lower surfaces A and B for hole and electron injection respectively. Two connector islands in close proximity form an emissive domain 505. The device is has two external electrodes 502 and 507, one or both being semitransparent.

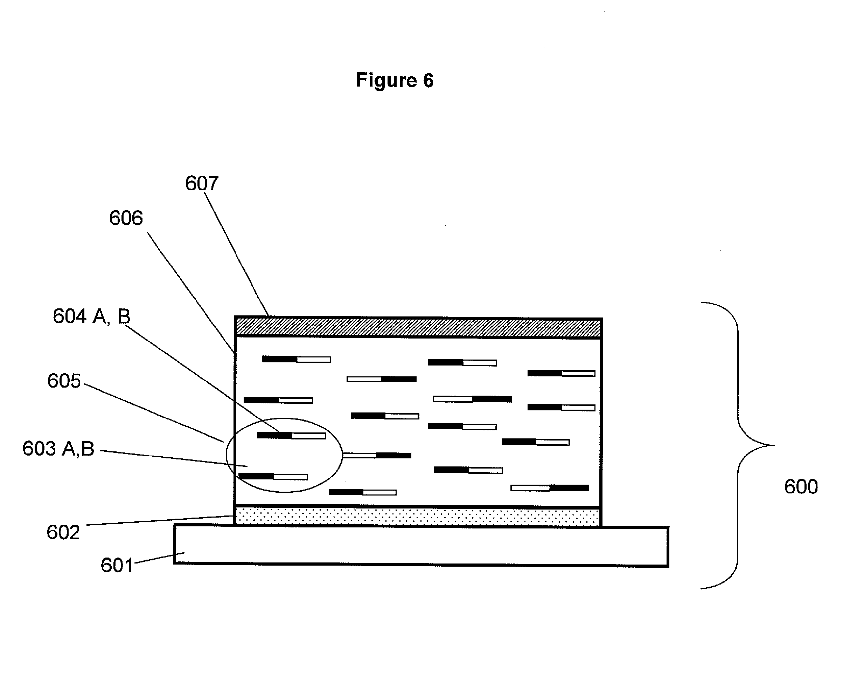

Figure 6 is a schematic side cross-section view of a multidomain device 600 according to the present invention, in which interconnect islands are embedded randomly in an emissive matrix 606. The connecting islands e.g. 603 and 604 are nanowires, having different ends with surfaces A and B for hole and electron injection respectively. Two connector islands in close proximity form an emissive domain 605. The device has two external electrodes 602 and 607, one or both being semitransparent.

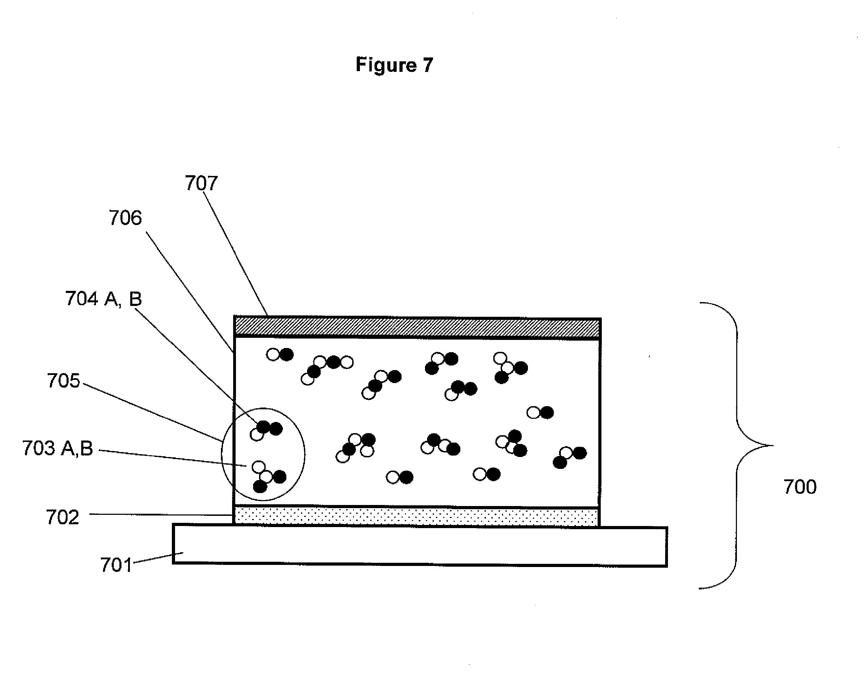

Figure 7 is a schematic side cross-section view of a multidomain device 700 according to the present invention, in which interconnect islands are embedded randomly in an emissive matrix 706. The connecting islands e.g. 703, 704 are clusters, having different surfaces A and B for hole and electron injection respectively. Two connector islands in close proximity form an emissive domain 705. The device has two external electrodes 702 and 707, one or both being semitransparent.

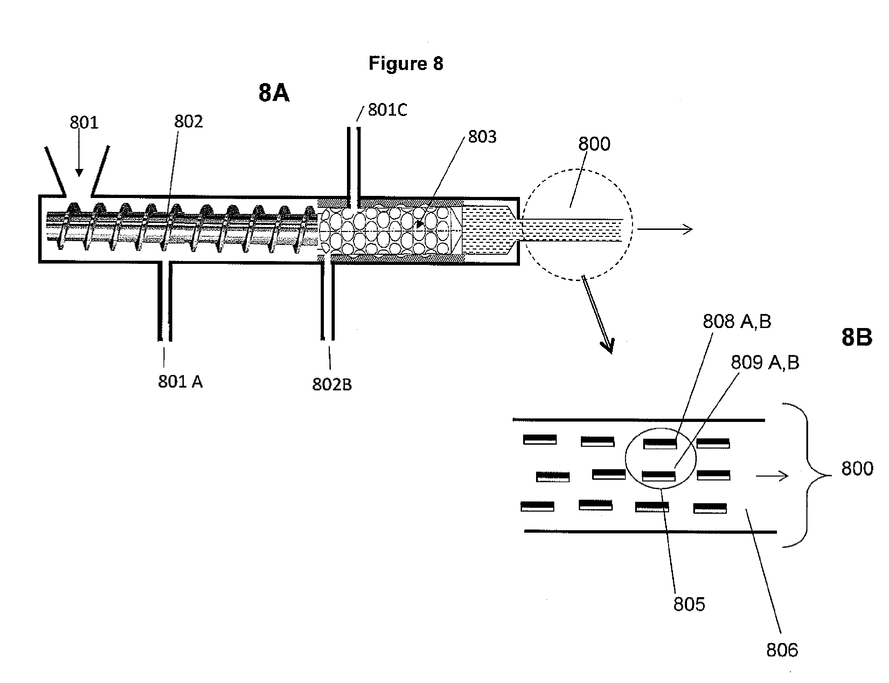

Figure 8 is a schematic side cross-section view of a process for manufacturing an extruded multidomain device 800 according to the present invention. The emissive matrix material and the interconnect islands are fed into a single or multiple screw extruder 802 optionally comprising a cavity transfer mixing zone 803. The materials of the multidomain film or layer may be fed through ports 801, 801A, 801B or 801C as solid pellets or as a solutions or dispersions. Fewer or more ports can be provided as desired. The extruder blends the emissive matrix materials and the island materials under pressure and extrudes the blend into a film or a layer 800 at the exit port. The islands align in the direction of the flow to form random interconnects as shown in the magnified image of Figure 8B. A random array of connector islands are produced in the bulk of the film 806. Each island has two surfaces A and B for hole and electron injection respectively. Two connector islands in close proximity e.g. 808 and 809 form an emissive domain 805. External electrodes are applied to the structure at a subsequent step.

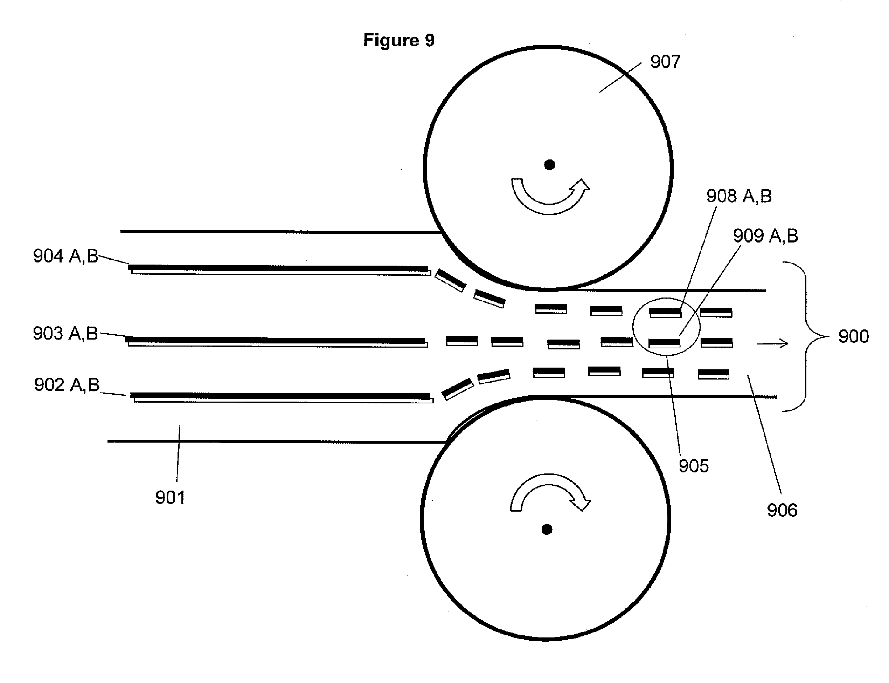

Figure 9 is a schematic side cross-section view of a device 900 according to the present invention manufactured by hot rolling a multilayer film 901 with roller 907. The laminate film 801 may initially comprise an emissive matrix with continuous interlayers 902, 903 and 904 each having an upper and lower surface A and B for hole and electron injection respectively. As the multilayer stack is rolled from left to right, random connector islands 908 and 909 are produced at the point of thinning and stretching the film causing the emissive matrix to stretch and simultaneously the interlayer to break up into islands. Two connector islands in close proximity e.g. 908 and 909 form an emissive domain 905. External electrodes are applied to the structure at a subsequent step.

### Detailed description of the invention

In each embodiment illustrated in Figures 5,6 and 7 the device comprises in effect multiple small series connected OLED domains. The interconnect islands in each case comprise materials having two types of surfaces for hole and electron injection respectively. The number of domains across the layer vertically (i.e. in a direction from an electrode of one polarity to an electrode of the other polarity) is determined by the density of the interconnect islands within the emissive matrix. Such architecture has the benefit that any local defect will only damage or short one OLED domain within the matrix. Gradually developing shorts will also affect only locally the device. The effective average number of "OLED domains" vertically is ideally at least ten in order to reduce the variance of layer numbers across large areas and ensure uniformity. However, if the distribution of the islands is well controlled, a lower average number of vertical domains can be considered, for example 2 to 9. By having 10 or more "effective" vertical OLED domains the device thickness can be increased to several microns, greatly aiding uniformity of deposition.

In one embodiment, the average number of domains is about 10, leading thus to an OLED device which can be driven at 40 - 50 Volts, which is still considered low voltage for safety purposes. The current requirement of such a device per area is reduced. In another embodiment, the device is characterised by an average vertical domain number of 20-60, which makes it possible to drive the device from 110 V or 240 V mains after rectification. Such devices can reach thicknesses of 5 microns to even tens of microns, which is advantageous for ease of manufacture. The average number of vertical domains is not limited and can be any number, for example from 2 to 300, depending on the drive voltage and drive mode preferred.

An important purpose of the present invention is to enable thick film coating of OLED, in particular making it possible to provide novel OLED shapes OLED by extrusion, moulding or thermal forming.

A key performance advantage of a random vertical OLED domain stack is that each domain can be driven at low current and low brightness yet the sum of the light output of the domains may be high. OLED devices last longer when driven at low currents and can yield better current efficiencies at low brightness.

The present invention offers multiple advantages in terms of manufacturability, yield, power efficiency and matching increased voltage drive schemes that avoid ohmic losses and require lower conductivity transparent electrodes and/or interconnects and cabling.

### Preferred interconnect islands

Figure 5 illustrates a random interconnect structure in which the interconnect islands 503 and 504 are flat with two different upper and lower surfaces A and B. Such islands can be, for example two different metals on top of each other, one with a high work function for injection of holes (anode-like) and one with low work function for injection of electrons (cathode-like). Examples of typical anode-like materials are Au, Pt, indium tin oxide (ITO), indium zinc oxide (IZO), WO₃, MoO₃ or V₂O₅. Examples of cathode-like materials are Ca, Al, Ag, LiF, Mg or Cu, and the like, including their alloys. The islands with two types of surfaces can be formed, for example, by subsequent evaporation of two or more metals. Evaporation can be conducted in situ while forming the device, in which case thin islands are formed, stopping growth before the layer would become continuous. The islands may also comprise metal flakes, which can be produced by evaporation, sputtering or plating processes. It is preferred that the islands are transparent, although reflective islands may also be considered. The interconnect islands may also comprise pairs or clusters of joined metal nanowires or nanoparticles, having at least two types of surfaces with different work functions to aid hole and electron injection as shown in Fig. 6 and 7.

The interconnect islands may comprise inorganic semiconductors such as CdSe, CdS, ZnO, alloys of InGaZnO, Silicon, boron nitride in the form of nanorods, flakes or nanowires. In each case each domain has at least two types of surfaces to aid hole or electron injection respectively. The surfaces are defined by either having two types of semiconductors joined or one semiconductor doped n or p type on the two respective surfaces. Semiconductor interconnect islands may also comprise pairs or clusters of joined metal nanowires or nanoparticles, having at least two types of surfaces with different work functions to aid hole and electron injection as shown in Fig. 6 and 7. Interconnect materials may comprise MoO₃ for hole injection and/or Cs₂CO₃. Suitable materials are described in the SID Digest of Technical Papers, p,154, (2004), in Applied Physics Letters, 87, 241121 (2005), Applied Physics Letters 92, 043301 (2008). Cs₂CO₃ materials can be incorporated from a solution process as described in Advanced Functional Materials, V17, p1966 (200&). The surface for hole injection may further comprise V₂O₅.

The interconnect islands may also comprise organic materials such combinations of as graphene, organic pigments such as phthalocyanines and their flakes, crystals or aggregates. Organic materials used in tandem OLED devices can also be used to form islands that have surfaces to inject holes and electrons respectively. For example, the islands may comprise a combination of n-doped organic materials and p doped organic materials on either side of the interconnect island. Suitable materials for this arrangement are described in US6,717,358. Examples of materials for electron injection include tris(8-Hydroxyquinolate) aluminum (Alq3) or bathocuprene (BCP), optionally doped with Cs₂CO₃. Any electron transporting molecule or polymer can be considered such as bathocuprene, triazine molecules or (2-(4-ter-Butylphenyl)-5-4(-biphenyl)-1, 3, 4-oxidiazole (butyl-PBD). Examples of materials for hole injection include doped hole transport materials such as {4,4'-bis[N-(1-naphy)-N-phenyl-amino]bipheny} (known as NPD), or other doped hole transport materials from tryarylamine, stilbene, hydrazone classes such as TPD, TAA, TCTA and others for example those described by Borsenberger and Weiss in "Organic Photoconductors for Imaging Systems" , Marcel Dekker 1993. They may also comprise doped polymers such as (poly-ethylene dioxythiophene) /poly(styrene sulphonate)] (known as PEDOT/PSS) or doped polyaniline (PAni) layers. Surface layers for hole injection may be effectively doped with strong acceptors such as tetrafluorotetracyano-quinadimethane (F₄-TCNQ). The materials used as the p-type dopants in the p-type doped organic layer of the connecting islands may be oxidizing agents with strong electron-withdrawing properties. By "strong electron-withdrawing properties" it is meant that the organic dopant should be able to accept some electronic charge from the host to form a charge-transfer complex with the host. Some non-limiting examples include organic compounds such as 2,3,5,6-tetrafluoro-7,7,8,8-tetracyanoquinodimethane (F₄-TCNQ) and other derivatives of TCNQ, and inorganic oxidizing agents such as iodine, FeCl₃, FeF₃, SbCl₅, and some other metal halides. In the case of polymeric hosts, the dopant can be any of the above or also a material molecularly dispersed or copolymerized with the host as a minor component.

Examples of materials that can be used as host for either the n-type or p-type doped organic layers include, but are not limited to: various anthracene derivatives as described in US5,972,247; certain carbazole derivatives, such as 4, 4-bis(9-dicarbazolyl)-biphenyl (CBP); and distyrylarylene derivatives such as 4,4'-bis(2,2'-diphenyl vinyl)-1,1'-biphenyl and as described in US5,121,029.

The interconnect islands may be a combination of metals, organic semiconductors and/or inorganic semiconductors as long as the islands provide two different surfaces capable of injecting electrons and holes respectively.

The size of the interconnect islands may be from 3 Angstroms to 10mm, more preferably from 5nm to 1µm, even more preferably from 5nm to 100nm.

The interconnect islands may be provided as a cluster of nanoparticles or organic molecules. Such clusters can be induced by dispersing or dissolving materials in a two phase polymer matrix that will confine islands in one phase. For example block copolymers or polymer blends can be used for this purpose. The emissive matrix surrounding the islands may optionally contain inert binder polymers such as polystyrene, polycarbonate, polynaphthalene or their copolymers. Block copolymers are particularly suitable to confine interconnect domains in one of their phases. Suitable binders are described for example, in US7576208 and US7095044. Binder polymers described in these documents are hereby incorporated by reference. Preferably the emissive matrix comprises at least one active or inactive polymeric material such as polyvinylcarbazole or polystyrene to provide integrity to the stack.

Any combination of interconnect materials can be considered for the islands, as long as they provide two surfaces effective for hole and electron injection.

The materials used as the n-type dopants in the n-type doped organic layer of the connecting islands include metals or metal compounds having a work-function less than 4.0 eV. Particularly useful dopants include alkali metals, alkali metal compounds, alkaline earth metals, and alkaline earth metal compounds. The term "metal compounds" includes organometallic complexes, metal-organic salts, and inorganic salts, oxides and halides. Among the class of metal-containing n-type dopants, Li, Na, K, Rb, Cs, Mg, Ca, Sr, Ba, La, Ce, Sm, Eu, Th, Dy, or Yb, and their inorganic or organic compounds, are particularly useful. The materials used as the n-type dopants in the n-type doped organic layer of the connecting units also include organic reducing agents with strong electron-donating properties. By "strong electron-donating properties" it is meant that the organic dopant should be able to donate at least some electronic charge to the host to form a charge-transfer complex with the host. Non-limiting examples of organic molecules include bis(ethylenedithio)-tetrathiafulvalene (BEDT-TTF), tetrathiafulvalene (TTF), and their derivatives. In the case of polymeric hosts, the dopant can be any of the above or also a material molecularly dispersed or copolymerized with the host as a minor component.

### Preferred deposition techniques

The OLED devices of the present invention may be deposited by any coating technique such as spin-, slit die-, wire-bar-, curtain- or dip coating. The devices can also be printed by inkjet, flexographic or gravure printing, screen printing and the like. Especially preferred techniques are extrusion coating, extrusion printing and moulding. These techniques can also be used to incorporate interconnect islands into the emissive matrix. Extrusion and moulding are techniques that are particularly suitable to align the islands in the plane of the emissive layer as illustrated in Figure 8. The extrusion process may contain solvents or may rely on melting the composition.

The multidomain OLED structure may be shaped into a freestanding thick film or curved shape with subsequent deposition of external anode and cathode electrodes.

The multidomain OLED device may also be formed by alternate coating or lamination of emissive layers and an interconnect material as shown in Fig 9. Random islands can be formed by stretching or rolling the multilayer laminate, which causes the interconnect material to break up into islands horizontally in the process. An advantage of this technique is that the emissive stack can be provided initially as a thick laminate, at multiples of the final device thickness. During the stretching process the multilayer stack becomes thinner. Suitable techniques to stretch the stack into a random multilayer domain arrangement are, for example, uniaxial or biaxial stretching, hot rolling or moulding.

Any deposition technique can be used as long as it ensures that the interconnect islands are incorporated to give rise to a series of OLED domains within the layer.

### Preferred OLED materials

The emissive matrix in which the interconnect domains are disposed comprises at least one electroluminescent material which can be a small molecule, polymeric or oligomeric compound. One or more of the materials in the matrix can be an electron injection material. One or more of the matrix materials can be an electron transport material. One or more of the OLED materials can be photoluminescent or phosphorescent material. One or more of the matrix materials can be a hole transport material. One or more of the matrix materials can be a hole injecting material. One or more of the deposited materials can be an exciton blocking material. One or more of the deposited materials can be a light absorbing material. One or more materials can be a dye or organic/inorganic pigment to correct colour.

The emissive or transport materials may be small molecule oligomeric or polymeric in nature. Any organic semiconductor material can be considered for the matrix. Organic semiconductors are typically heteroaromatic molecules or polymers. Some chemical classes of organic semiconductors include thiophenes, oxidiazoles, perylenes, phthalocyanines, arylamines, carbazoles.

Some examples of small molecule materials are those used in the production of OLED components, such as electron transport layer (ETL) materials-Aluminum Tri (8-Hydroxyquinolinate) (Alq.sub.3); hole injection layer (HIL) materials-Copper Phthalocyanine (CuPc); hole transport (HTL) layer materials-N,N'-bisphenyl-N,N'-bis(1-naphthyl)-benzidine (abbreviated as NPB) or N,N'-Bisphenyl-N,N'-bis(3-methylphenyl)-benzidine (TPD), bathocuprine (BCP), or fac tris(2-phenylpyridine) iridium (Irppy). Pentacene or substituted pentacene derivatives may also be used.

Polymeric materials may be polythiophenes, polyvinylphenylenes (PVP), polyfluorenes, polyspiro or polycarbazole materials and the like. Any copolymer of consisting of active units of the above small molecule or polymeric semiconductor classes can also be considered. Any OLED material, emissive, transport or dopant like material can be considered as long as it forms an effective interface with the embedded interconnect islands.

### Examples

### Example1 :

A 10 microns thick film is extruded using a twin-screw extruder system with die temperature below 200 degC. 10%wt (1,1'-biphenyl-4'-oxy)bis(8-hydroxy- 2-methylquinolinato)-aluminum, 30%wt N,N'-Bis(3-methylphenyl)-N,N'-diphenyl-benzidine and less than 1% Al-Au bimetallic flakes are added to the polycarbonate melt prior to extrusion.

The extruded film is subsequently coated with 200nm evaporated Ag on one side and 20nm evaporated Au on the other side in order to define external electrodes.

Light emission is achieved by applying a voltage across the external electrodes so that the Ag film and the Au film act as cathode and anode respectively.

Al-Au flakes are fabricated by evaporating 5nm of Al and 15nm of Au onto a sacrificial polymer layer coated onto a substrate. The bimetallic film is release from the substrate by wet etching the polymer layer and subsequently broken down into flakes by ball milling.

### Example2:

A 1 micron thick film is formed by bar-coating a solution over an ITO coated glass. The single layer contains 60%wt Poly(vinylcarbazole), 29%wt 1,3-bis[(4-tert-butylphenyl)-1,3,4-oxadiazolyl]phenylene, 10%wt bis[(4,6-difluoro-phenyl)- pyridinato-N,C2](picolinato)Ir(III)and 1% bimetallic Ag-Pt bimetallic nanowires.

A cathode layer is fabricated over the layer described above by depositing 150nm of Al by thermal evaporation.

Light emission is achieved by applying a voltage between the ITO layer acting as anode and the top Al layer acting as cathode.

To fabricate the nanowires, first a metallic layer is deposited by PVD onto one side of a porous inorganic membrane which is then used as electrode for the sequential electrodeposition of further silver and platinum. To release the nanowire the silver layer is partially etched and the inorganic membrane is wet etched.

### Example3:

A 500nm light emitting layer is deposited by spin coating onto an ITO coated glass substrate. The layer contains around 1%wt of Ag capped carbon nanotubes dispersed in poly[2-methoxy-5-(2'-ethylhexoxy-*p*-phenylene vinylene].

A cathode layer is fabricated over the layer described above by depositing 1nm LiF and 150nm of Al by thermal evaporation.

Light emission is achieved by applying a voltage between the ITO layer acting as anode and the top Al layer acting as cathode.

The Ag capped carbon nanotubes are fabricated as follows. CNTs are grown by CVD onto a (carrier) substrate and subsequently encapsulated by lamination of a second (transfer) substrate coated with polymer. Following curing of the polymer the nanoparticles are lifted off from the carrier substrate to be held within the polymer layer of the transfer substrate. Partial etching of the polymer matrix allows partial coating of the CNTs with silver by thermal evaporation. Nanoparticles can be released by wet etching of the remaining polymer layer.

It will be appreciated by persons skilled in the art that the above embodiments have been described by way of example only and not in any limitative sense, and that various alterations and modifications are possible without departure from the scope of the invention as defined by the appended claims.

## Claims

1. An emissive element for a device for emitting electromagnetic radiation, the emissive element comprising:-
at least one emissive layer including at least one organic material; and
a plurality of interconnect islands embedded in at least one predetermined said emissive layer and separated from each other, wherein each of a plurality of said interconnect islands comprises respective electron injecting means and respective hole injecting means, wherein at least one emissive domain is defined by at least part of said electron injecting means of a respective first said interconnect island, at least part of said hole injecting means of a respective second said interconnect island adjacent said first interconnect island and a respective region of said emissive layer separating said electron injecting means and said hole injecting means, and wherein application of a suitable electric field to the emissive layer in use in a device for emitting electromagnetic radiation causes electron injecting means and hole injecting means of at least one said domain to supply electrons and holes respectively, to cause said at least one said emissive domain to emit electromagnetic radiation.

2. An element according to claim 1, wherein at least one said emissive layer includes at least one organic electroluminescent material.

3. An element according to claim 1 or 2, wherein at least one said interconnect island includes nanoparticles and/or nanowires and/or flakes and/orat least one metallic material and/or at least one semiconducting material and/or at least one organic material.

4. An element according to claim 3, wherein at least one said interconnect island includes clusters of least one said metallic material and/or at least one said semiconducting material and/or at least one said organic material.

5. An element according to any one of the preceding claims, wherein at least one said interconnect island comprises at least one coating and/or surface treatment for enabling and/or enhancing electron and/or hole injection by said island.

6. An element according to any one of the preceding claims wherein at least one said emissive layer includes at least one polymeric material.

7. An element according to any one of the preceding claims, wherein at least one said electron injecting means comprises at least one respective electron injecting surface substantially in a plane substantially parallel to at least one first and/or second surface of said layer, and/or wherein at least one said hole injecting means comprises at least one respective hole injecting surface substantially in a plane substantially parallel to at least one said first and/or second surface of said layer.

8. An element according to any one of the preceding claims, wherein a plurality of said interconnect islands are elongate with respective electron injecting means and hole injecting means provided adjacent opposite ends thereof.

9. A device for emitting electromagnetic radiation, the device comprising:
at least one first electrode;
at least one second electrode; and
at least one element according to any one of the preceding claims arranged between at least one said first electrode and at least one said second electrode.

10. A material for forming an emissive element for a device for emitting electromagnetic radiation, the material comprising an emissive material including at least one organic material, and a plurality of interconnect islands embedded in said emissive material, wherein each of a plurality of said interconnect islands comprises respective electron injecting means and/or respective hole injecting means.

11. A material according to claim 10, wherein said emissive material is adapted to be made flowable at room temperature by means of at least one solvent and/or is adapted to be made flowable by means of melting.

12. A method of manufacturing an emissive element for a device for emitting electromagnetic radiation, the method comprising:-
providing at least one flowable material including at least one organic material;
introducing a plurality of components into said flowable material wherein a plurality of said components comprise respective electron injecting means and/or respective hole injecting means; and
forming a layer from said flowable material together with said components such that a plurality of said components are embedded in said layer and separated from each other.

13. A method according to claim 12, further comprising the step of treating at least one said component, subsequently to formation of said layer, to create and/or enhance respective electron injecting means and/or respective hole injecting means.

14. A method according to claim 12 or 13, wherein said layer is formed by means of melt processing and/or solution processing and/or extrusion and/or extrusion printing and/or solution coating and/or moulding and/or spraying and/or inkjet printing.

15. A method according to any one of claims 12 to 14, wherein a plurality of said components are dispersed in said flowable material by means of preferential dispersion in a polymer phase and/or dissolution in a polymer phase.
